# EUROPEAN PATENT APPLICATION

(11) **EP 4 672 430 A1**
(43) Date of publication of application: **31.12.2025**
(21) Application number: 23923639.1
(22) Date of filing: 01.08.2023
(51) Int. Cl.: H01M 10/63, H01M 10/613, H01M 10/6556, H01M 10/6563, H01M 10/6568, H01M 10/6569, H01M 10/663, H01M 10/667, H01M 10/615, H01M 10/6571, H05K 7/20

(54) **ENERGY STORAGE THERMAL MANAGEMENT SYSTEM AND METHOD**

(30) Priority: 22.02.2023 CN 202310167244
(71) Applicant: Sungrow Power Supply Co., Ltd., Hefei, Anhui 230088 (CN)
(72) Inventor: FANG, Ri, Hefei, Anhui 230088 (CN); BAO, Tong, Hefei, Anhui 230088 (CN); CAO, Renxian, Hefei, Anhui 230088 (CN); XU, Qingqing, Hefei, Anhui 230088 (CN)
(74) Representative: Epping - Hermann - Fischer
(86) International application number: PCT/CN2023/110502
(87) International publication number: WO 2024/174472

(57) **Abstract**

Provided in the present invention are an energy storage thermal management system and method. The energy storage thermal management system comprises a controller, a battery, a power electronic device, and a shunting apparatus. The controller determines the operating mode of the energy storage management system, the operating mode being any one of a preset first mode, second mode and third mode; and according to the operating mode of the energy storage thermal management system, controls a corresponding path of the shunting apparatus to be turned on, so that in the first mode, the battery performs heat exchange in a compression cooling mode and the power electronic device performs heat exchange in a liquid-cooled heat exchange mode; in the second mode, the battery and the power electronic device both perform heat exchange in the liquid-cooled heat exchange mode; and in the third mode, the power electronic device and/or an electric heater perform heat exchange with the battery. The present invention can select different heat exchange modes for the battery and the power electronic device according to different operating modes, so as to meet the heat dissipation requirements of the battery and the power electronic device.

## Description

This application claims the priority to Chinese Patent Application No. 202310167244.8, titled "ENERGY STORAGE THERMAL MANAGEMENT SYSTEM AND METHOD", filed on February 22, 2023 with the China National Intellectual Property Administration, which is incorporated herein by reference in its entirety.

### FIELD

The present application relates to the technical field of thermal management, and in particular to an energy storage thermal management system and method.

### BACKGROUND

Currently, containers or battery cabinets of energy storage systems are mostly composed of batteries as the sole energy storage component. However, with the development of the energy storage industry, more and more energy storage systems are evolving towards fully prefabricated solutions. For instance, a power electronic device such as a Power Conversion System (PCS) is also integrated into a container or a battery cabinet.

**In** the case that both a battery and a power electronic device such as PCS are integrated into the same container or battery cabinet, the heat dissipation requirements of the battery and the power electronic device are different. Therefore, how to simultaneously meet the heat dissipation requirements for the battery and the power electronic device has become an urgent technical problem to be solved by those skilled in the field.

### SUMMARY

In view of this, an energy storage thermal management system and method are provided according to the present application, to solve the urgent technical problem of simultaneously meeting the heat dissipation requirements of the battery and the power electronic device.

To address the above technical issue, the present application provides the following technical solutions.

An energy storage thermal management system includes a controller, a battery, a power electronic device, and a fluid diverter; where
the controller is configured to:
determine an operating mode of the energy storage management system, where the operating mode is any one of a first mode, a second mode or a third mode that are preset; and
control a corresponding passageway of the fluid diverter to be opened based on the operating mode of the energy storage thermal management system, so that
   in a case that the operating mode is the first mode, the battery exchanges heat in a compression cooling mode and the power electronic device exchanges heat in a liquid-cooling heat exchange mode;
   in a case that the operating mode is the second mode, both the battery and the power electronic device exchange heat in a liquid-cooling heat exchange mode; and
   in a case that the operating mode is the third mode, the battery exchanges heat with the power electronic device, and/or the battery exchanges heat with an electric heater.

In an embodiment, the energy storage thermal management system includes a compression refrigeration loop and a liquid-cooling loop, the power electronic device is located in the liquid-cooling loop, the compression refrigeration loop and the liquid-cooling loop share a liquid-cooling condenser, and the energy storage thermal management system exchanges heat through fluid.

In an embodiment, the energy storage thermal management system includes a heat dissipation loop including a compression refrigeration loop and a liquid-cooling loop.

In an embodiment, in the energy storage thermal management system, in the case that the operating mode is the first mode, a condenser used in the compression refrigeration mode is a liquid-cooling condenser, and the liquid-cooling condenser and the power electronic device are in a same liquid-cooling loop.

In an embodiment, in the energy storage thermal management system, the liquid-cooling condenser and the power electronic device are connected in series in the liquid-cooling loop.

In an embodiment, the energy storage thermal management system includes at least one heat exchanger, and the controller is configured to:
control the corresponding passageway of the fluid diverter to be opened, so that the power electronic device, the at least one heat exchanger, the fluid diverter, and the liquid-cooling condenser are connected to form a first liquid-cooling loop to realize heat dissipation of the power electronic device in the liquid-cooling heat exchange mode, and the battery, the fluid diverter, and an evaporator in the compression refrigeration loop are connected to form a second liquid-cooling loop to realize heat dissipation of the battery in the compression refrigeration mode.

In an embodiment, in the energy storage thermal management system, the fluid diverter includes a valve assembly with multiple preset passageways; and the controller is configured to control the corresponding passageway of the valve assembly with the multiple preset passageways to be opened, so that the power electronic device, the fluid diverter, the liquid-cooling condenser, and the at least one heat exchanger are connected to form the first liquid-cooling loop, and the battery, the fluid diverter, and the evaporator in the compression refrigeration loop are connected to form the second liquid-cooling loop.

In an embodiment, in the energy storage thermal management system, the liquid-cooling condenser and the power electronic device are connected in parallel in the liquid-cooling loop; and
in a case that the energy storage thermal management system includes at least one heat exchanger and the fluid diverter includes a valve assembly with multiple preset passageways, a low-temperature coolant output from the at least one heat exchanger is distributed through a specified valve assembly in the fluid diverter and flows through fluid channels of the liquid-cooling condenser and the power electronic device, respectively.

In an embodiment, in the energy storage thermal management system, in the case that the operating mode is the second mode, the controller controls the corresponding passageway of the fluid diverter to be opened to form a third liquid-cooling loop including the battery and a fourth liquid-cooling loop including the power electronic device, and the third liquid-cooling loop and the fourth liquid-cooling loop are independent of each other.

In an embodiment, the energy storage thermal management system includes two heat exchangers, where one of the two heat exchangers is located in the third liquid-cooling loop and the other of the two heat exchangers is located in the fourth liquid-cooling loop.

In an embodiment, the energy storage thermal management system includes at least one heat exchanger; and
in the case that the operating mode is the second mode, the controller controls the corresponding passageway of the fluid diverter to be opened to form a fifth liquid-cooling loop; and the battery and the power electronic device are connected in series in the fifth liquid-cooling loop and share the heat exchanger for heat dissipation.

In an embodiment, the energy storage thermal management system includes at least one heat exchanger; and
in the case that the operating mode is the second mode, the controller controls the corresponding passageway of the fluid diverter to be opened to form a sixth liquid-cooling loop; and the battery and the power electronic device are connected in parallel in the sixth liquid-cooling loop and share the heat exchanger for heat dissipation.

In an embodiment, in the energy storage thermal management system, in the case that the operating mode is the third mode, the battery is arranged on a battery cold plate, the power electronic device is arranged on a power electronic device cold plate, and the controller controls the corresponding passageway of the fluid diverter to be opened, so that the battery cold plate, the power electronic device cold plate, and the fluid diverter are connected to form a seventh liquid-cooling loop, so as to use the heat of the power electronic device to heat the battery.

In an embodiment, in the energy storage thermal management system, the electric heater is arranged in the seventh liquid-cooling loop, and the controller is further configured to heat the battery and the power electronic device by using the electric heater.

In an embodiment, in the energy storage thermal management system, in the case that the operating mode is the third mode, the corresponding passageway of the fluid diverter is controlled to be opened, so that the electric heater, the battery, and the fluid diverter are connected to form an eighth liquid-cooling loop, so as to use the electric heater to heat the battery.

An energy storage thermal management method, applied to the controller in the energy storage thermal management system described above, includes:
determining a current operating mode of the energy storage thermal management system, in a case that the energy storage thermal management system meets a preset operating mode switching condition, where the operating mode is one of a first operating mode, a second operating mode, or a third operating mode; and
controlling a corresponding passageway of the fluid diverter to be opened based on the operating mode of the energy storage thermal management system, so that
   in a case that the operating mode is the first mode, the battery exchanges heat in a compression refrigeration mode and the power electronic device exchanges heat in a liquid-cooling heat exchange mode;
   in a case that the operating mode is the second mode, both the battery and the power electronic device exchange heat in a liquid-cooling heat exchange mode; and
   in a case that the operating mode is the third mode, the battery exchanges heat with the power electronic device and/or the battery exchanges heat with the electric heater.

In an embodiment, in the energy storage thermal management method, the process of detecting that the energy storage thermal management system meets the preset operating mode switching condition includes:
acquiring a current ambient temperature and determining a previous operating mode of the energy storage thermal management system; and
determining that the energy storage thermal management system meets the preset operating mode switching condition, if the current ambient temperature is not within a temperature range corresponding to the previous operating mode, and a minimum temperature difference between the current ambient temperature and the temperature range is greater than a preset hysteresis threshold.

In an embodiment, in the energy storage thermal management method, the determining the current operating mode of the energy storage thermal management system includes:
acquiring the current ambient temperature;
determining a target temperature range within which the current ambient temperature falls; and
determining an operating mode corresponding to the target temperature range as the current operating mode of the energy storage thermal management system.

Compared with the conventional technology, the present application has the following beneficial effects.

An energy storage thermal management system and method are provided according to the present application. The energy storage thermal management system includes a controller, a battery, a power electronic device, and a fluid diverter. The controller determines the operating mode of the energy storage management system, and the operating mode is any one of a first mode, a second mode, or a third mode that is preset. The controller controls the corresponding passageway of the fluid diverter to be opened based on the operating mode of the energy storage thermal management system, such that: in the first mode, the battery exchanges heat in a compression refrigeration mode and the power electronic device exchanges heat in a liquid-cooling heat exchange mode; in the second mode, both the battery and the power electronic device exchange heat in a liquid-cooling heat exchange mode; and in the third mode, the power electronic device and/or the electric heater exchange heat with the battery. In other words, through the present application, heat dissipation of the battery and the power electronic device in different modes is achieved, and different heat dissipation modes are selected based on different operating modes, which meets the heat dissipation requirements for the battery and the power electronic device, and solves the urgent problem of simultaneously meeting the heat dissipation requirements for the battery and the power electronic device.

### BRIEF DESCRIPTION OF THE DRAWINGS

In order to clearly illustrate technical solutions in the embodiments of the present application or in the conventional technology, drawings required in the description of the embodiments or the conventional technology are briefly described below. Apparently, the drawings in the following description are only some embodiments of the present application, and other drawings can be obtained by those skilled in the art based on the provided drawings without any creative effort.
FIG. 1 is a schematic structural view of an energy storage thermal management system according to an embodiment of the present application;
FIG. 2 is a schematic structural view of an energy storage thermal management system according to another embodiment of the present application;
FIG. 3 is a schematic structural view of an energy storage thermal management system according to yet another embodiment of the present application;
FIG. 4 is a schematic structural view of an energy storage thermal management system according to still another embodiment of the present application;
FIG. 5 is a schematic structural view of an energy storage thermal management system according to a fifth embodiment of the present application;
FIG. 6 is a schematic structural view of an energy storage thermal management system according to a sixth embodiment of the present application;
FIG. 7 is a schematic structural view of an energy storage thermal management system according to a seventh embodiment of the present application;
FIG. 8 is a schematic structural view of an energy storage thermal management system according to an eighth embodiment of the present application;
FIG. 9 is a schematic structural view of an energy storage thermal management system according to a ninth embodiment of the present application;
FIG. 10 is a schematic structural view of an energy storage thermal management system according to a tenth embodiment of the present application;
FIG. 11 is a schematic structural view of an energy storage thermal management system according to an eleventh embodiment of the present application;
FIG. 12 is a schematic structural view of an energy storage thermal management system according to a twelfth embodiment of the present application;
FIG. 13 is a schematic structural view of an energy storage thermal management system according to a thirteenth embodiment of the present application;
FIG. 14 is a schematic structural view of an energy storage thermal management system according to a fourteenth embodiment of the present application;
FIG. 15 is a schematic structural view of an energy storage thermal management system according to a fifteenth embodiment of the present application; and
FIG. 16 is a flowchart of an energy storage thermal management method according to an embodiment of the present application.

### DETAILED DESCRIPTION OF THE EMBODIMENTS

The technical solutions of the embodiments of the present application are described clearly and completely as follows in conjunction with the drawings of the embodiments of the present application. It is apparent that the described embodiments are only some of the embodiments of the present application, rather than all of the embodiments. All other embodiments obtained by those skilled in the art based on the embodiments in the present application without any creative work fall within the protection scope of the present application.

Currently, containers or battery cabinets of energy storage systems are mostly composed of batteries as the sole energy storage component. The batteries typically use liquid-cooling thermal management systems to dissipate heat. A liquid-cooling thermal management system consists of a liquid-cooling unit (including a compressor, a condenser, a throttling device, a plate heat exchanger, a pump, a water tank, and an associated pipeline controller), a pipeline system, and a cold plate. The liquid-cooling unit is the core of the liquid-cooling thermal management system and provides power for circulation of a coolant, and heat brought by the coolant is dissipated to the air through the liquid-cooling unit. The liquid-cooling thermal management system includes two loops: a coolant circulation loop and a refrigerant circulation loop. A low-temperature coolant absorbs heat from the battery in a battery cold plate, and the temperature of the coolant rises. Then, the coolant transfers the heat to a refrigerant through the plate heat exchanger, returning to the low-temperature coolant. The liquid refrigerant absorbs heat from the coolant in the plate heat exchanger, vaporizes into a gaseous refrigerant, and then is compressed into a high-temperature and high-pressure gaseous refrigerant by the compressor. The high-temperature and high-pressure gaseous refrigerant dissipates heat to the air in the condenser, liquefies into high-pressure liquid refrigerant, and then becomes low-temperature and low-pressure liquid refrigerant through the throttling device, and enters the plate heat exchanger to absorb heat from the coolant.

The liquid-cooling thermal management system is used for heat dissipation, which provides an excellent heat dissipation effect for a battery as a single target. However, with the development of the energy storage industry, more and more energy storage systems are evolving towards fully prefabricated solutions. For instance, a power electronic device such as a Power Conversion System (PCS) is also integrated into a container or a battery cabinet.

In the case that both a battery and a power electronic device such as PCS are integrated into the same container or battery cabinet, the heat dissipation requirements of the battery and the power electronic device are different. For example, the battery and the power electronic device have different coolant temperature requirements for heat dissipation, the battery typically requires coolant at around 18 degrees Celsius, and the power electronic device typically requires coolant at around 50 degrees Celsius. If a liquid-cooling thermal management system is used to simultaneously cool the battery and the power electronic device, the temperature of the coolant for the power electronic device is around 20 degrees Celsius, resulting in low system energy efficiency and high costs.

Additionally, since the liquid-cooling unit has high requirements for the heat dissipation capacity of the condenser, the size of the condenser is generally large, leading to the large size of the liquid-cooling unit. Furthermore, the condenser needs to be introduced with a high-pressure refrigerant, and pipelines are typically welded to ensure system reliability, so the liquid-cooling unit cannot adopt a split-type design, and thus space utilization of the energy storage system cannot be maximized.

How to meet the heat dissipation requirements of both the battery and the power electronic device is an urgent technical problem to be solved by those skilled in the art.

An energy storage thermal management system and method are provided according to the present application. The energy storage thermal management system includes a controller, a battery, a power electronic device, and a fluid diverter. The controller is configured to determine an operating mode of the energy storage management system, where the operating mode is any one of a first mode, a second mode or a third mode that are preset. The controller is further configured to control a corresponding passageway of the fluid diverter to be opened based on the operating mode of the energy storage thermal management system, such that: in a case that the operating mode is the first mode, the battery exchanges heat in a compression refrigeration mode and the power electronic device exchanges heat in a liquid-cooling heat exchange mode; in a case that the operating mode is the second mode, both the battery and the power electronic device exchange heat in the liquid-cooling heat exchange mode; and in a case that the operating mode is the third mode, the battery exchanges heat with the power electronic device, and/or the battery exchanges heat with an electric heater. That is, through the present application, heat dissipation of the battery and the power electronic device is achieved in different modes, and different heat dissipation modes are selected based on the different operating mode, meeting the heat dissipation requirements for both the battery and the power electronic device and solving the urgent problem of simultaneously meeting their heat dissipation requirements.

In the embodiment, the energy storage thermal management system can provide corresponding heat exchange modes for the battery and the power electronic device simultaneously in different modes. The system has multiple operating modes, such as the first mode, the second mode, and the third mode. The different modes are switched based on ambient temperature. The switching of the different modes is achieved through the fluid diverter.

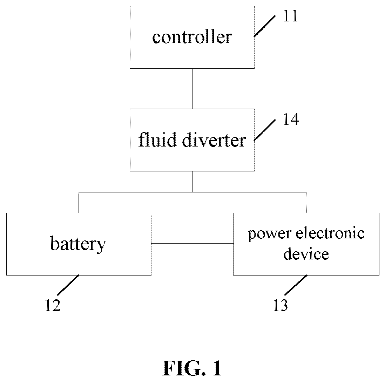

On the basis of the above, an energy storage thermal management system is provided according to an embodiment of the present application. Referring to FIG. 1, the energy storage thermal management system includes a controller 11, a battery 12, a power electronic device 13, and a fluid diverter 14. In the embodiment, the fluid diverter 14 may include at least one solenoid valve with a preset passageway, such as a multi-way valve.

The controller 11 is configured to control a corresponding passageway of the fluid diverter to be opened based on the operating mode of the energy storage thermal management system, such that: in a case that the operating mode is the first mode, the battery exchanges heat in a compression refrigeration mode and the power electronic device exchanges heat in a liquid-cooling heat exchange mode; in a case that the operating mode is the second mode, both the battery and the power electronic device exchange heat in a liquid-cooling heat exchange mode; and in a case that the operating mode is the third mode, the battery exchanges heat with the power electronic device, and/or the battery exchanges heat with an electric heater.

In an embodiment, the controller is configured to determine a current operating mode of the energy storage thermal management system based on a temperature range within which a current ambient temperature falls. The first mode may be a high-temperature mode, the second mode may be a medium-temperature mode, and the third mode may be a low-temperature mode.

In the embodiment, the power electronic device may include one or more of a PCS, a current conversion module DC/DC, and a switch box.

In the embodiment, in the first mode, the battery 12 may dissipate heat in a compression refrigeration mode, and the power electronic device 13 may dissipate heat in a liquid-cooling heat exchange mode. In the second mode, both the battery 12 and the power electronic device 13 exchange heat in a liquid-cooling heat exchange mode. In the third mode, the heat of the power electronic device 13 may be used to heat the battery.

In the embodiment, the battery and the power electronic device achieve heat exchange in different modes, and different heat exchange modes are selected based on different operating modes, meeting the cooling requirements for the battery and the power electronic device, and solving the problem of simultaneously meeting the heat dissipation requirements for the battery and the power electronic device.

In an embodiment of the present application, the energy storage thermal management system may include a compression refrigeration loop and a liquid-cooling loop.

In an embodiment, the compression refrigeration loop may include a compressor, an evaporator, a condenser, and a throttle valve. The condenser may be a liquid-cooling condenser. The controller is configured to control different preset passageways in the fluid diverter to be opened to form different liquid-cooling loops. The number of the liquid-cooling loop may be one or more, and each of the one or more liquid-cooling loops may consist of at least one of the battery or the power electronic device. The battery and the power electronic device may be in the same or different liquid-cooling loops. Each liquid-cooling loop may be provided with at least one pump to provide power for a coolant in the liquid-cooling loop.

In the embodiment, the battery and the power electronic device may be provided with coolant channels, respectively. The coolant channel of the battery may be a battery cold plate, and the coolant channel of the power electronic device may be a power electronic device cold plate. The fluid diverter may include a multi-way valve or multiple valves, where the multi-way valve includes multiple passageway nodes. One end of the coolant channel of the battery may be connected to a first passageway node of the fluid diverter, and the other end may be connected to a second passageway node of the fluid diverter through a first water pump and an evaporator in sequence. One end of the coolant channel of the power electronic device may be connected to a third passageway node of the fluid diverter, and the other end of the coolant channel of the power electronic device may be connected to a fourth passageway node of the fluid diverter. One end of a liquid-cooling channel of the condenser of the compression refrigeration loop may be connected to a fifth passageway node of the fluid diverter, and the other end may be connected to a sixth passageway node of the fluid diverter.

In the embodiment, the controller can control the fluid diverter to open the preset passageway corresponding to the operating mode. For example, in the case that the fluid diverter is a multi-way valve, the controller can control the corresponding passageway nodes of the fluid diverter to be connected to open the preset passageway, thereby forming the liquid-cooling loop corresponding to the operating mode, and thus meeting the heat exchange requirements of the battery and the power electronic device in different modes.

In some embodiments, the controller can control the preset passageway of the fluid diverter to be opened, enabling the power electronic device and the liquid-cooling condenser to be in the same liquid-cooling loop.

In the embodiment, the compression refrigeration loop in the energy storage thermal management system and the liquid-cooling loop where the power electronic device is located can share the liquid-cooling condenser. The energy storage thermal management system can exchange heat through a fluid, and the fluid may be a coolant. The compression refrigeration loop and the liquid-cooling loop where the power electronic device is located can share the liquid-cooling condenser, which can effectively save hardware costs and hardware layout space, improve the heat exchange efficiency of the power electronic device, and meet the heat exchange requirement for the power electronic device in the different operating modes.

In some embodiments, the controller is configured to determine the current operating mode of the energy storage thermal management system when it is detected that the energy storage thermal management system meets a preset operating mode switching condition.

Three operating modes are mentioned in the above embodiments, namely, the first mode, the second mode, and the third mode. The specific heat exchange modes of the battery and the power electronic device under each operating mode are introduced below.

In the embodiment, the heat dissipation loop of the energy storage thermal management system may be divided into a compression refrigeration loop and a liquid-cooling loop, so that the battery and the power electronic device can exchange heat in different heat exchange modes. In practical applications, a certain loop, such as the compression refrigeration loop, may or may not work in some operating modes, which is determined based on the actual situation.
1. The first mode is described as follows.

In another embodiment of the present application, the condenser used in the compression refrigeration mode is a liquid-cooling condenser, and the liquid-cooling condenser and the power electronic device are in the same liquid-cooling loop.

Based on different actual scenarios, the liquid-cooling condenser and the power electronic device are connected in series, or may be connected in parallel. In the embodiment, the case where the liquid-cooling condenser and the power electronic device are connected in series is first described.

In some embodiments, in the first mode, the energy storage thermal management system includes at least one heat exchanger. The controller controls the corresponding passageway of the fluid diverter to be opened, so that the power electronic device, the at least one heat exchanger, the fluid diverter, and the liquid-cooling condenser are connected to form a first liquid-cooling loop to allow the power electronic device to dissipate heat in a liquid-cooling heat exchange mode, and the battery, the fluid diverter, and the evaporator in the compression refrigeration loop are connected to form a second liquid-cooling loop to allow the battery to dissipate heat in a compression refrigeration mode.

In an embodiment, in the first mode, the controller is configured to control the fluid diverter to open the passageway corresponding to the first mode, thereby forming a first liquid-cooling loop and a second liquid-cooling loop. The first liquid-cooling loop may include the battery, a first water pump, and the evaporator in the compression refrigeration loop. The second liquid-cooling loop may include the power electronic device, a second water pump, at least one heat exchanger, and the liquid-cooling condenser in the compression refrigeration loop. The power electronic device and the liquid-cooling condenser may be connected in series or in parallel in the second liquid-cooling loop.

In the embodiment, the controller can activate the compressor in the compression refrigeration loop, the first water pump in the first liquid-cooling loop, the second water pump in the second liquid-cooling loop, and the heat exchanger, so that the battery can exchange heat in the compression refrigeration mode and the power electronic device can exchange heat in the liquid-cooling heat exchange mode.

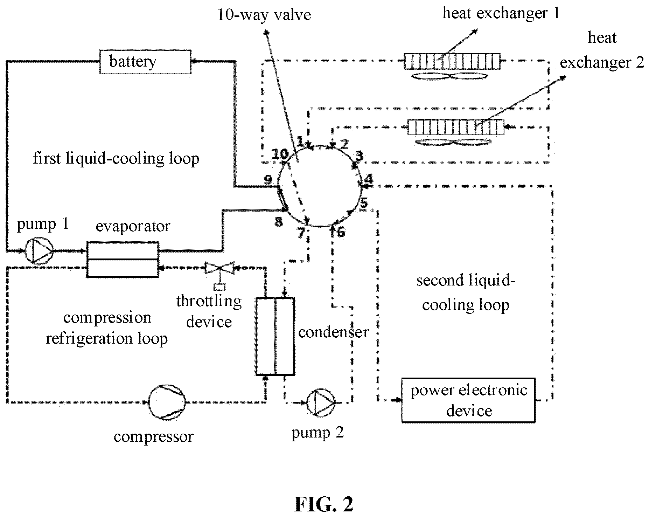

Specifically, referring to FIG. 2, the energy storage thermal management system includes: two heat exchangers, two water pumps, one fluid diverter, a battery, a power electronic device, and one compression refrigeration loop. The fluid diverter is a 10-way valve (or may be a valve group composed of multiple valves).

The energy storage thermal management system has three loops, namely a first liquid-cooling loop, the compression refrigeration loop, and a second liquid-cooling loop. FIG. 2 shows a schematic view of the system in the first mode. The fluid diverter includes a 10-way valve. The controller is configured to control a passageway node 1 to connect a passageway node 2, a passageway node 3 to connect a passageway node 4, a passageway node 5 to connect a passageway node 6, a passageway node 8 to connect a passageway node 9, and a passageway node 7 to connect a passageway node 10, in the 10-way valve. The first liquid-cooling loop is formed by connecting the water pump 1, the evaporator, the battery, pipelines, and the fluid diverter. The low-temperature coolant passes through the battery cold plate to cool the battery, and the temperature of the coolant rises. Then, the coolant flows through the evaporator to transfer heat to a refrigerant, and the temperature of the coolant decreases. The compression refrigeration loop consists of a compressor, the evaporator, a liquid-cooling condenser, a throttle device and so on. The low-temperature liquid refrigerant absorbs heat of the first liquid-cooling loop in the evaporator and vaporizes into gaseous refrigerant, and then it is compressed into high-temperature and high-pressure gaseous refrigerant by the compressor. Then, the refrigerant flows through the liquid-cooling condenser to transfer heat to the second liquid-cooling loop and liquefies into high-temperature and high-pressure liquid refrigerant, and passes through the throttle device to become low-temperature and low-pressure liquid refrigerant. The second liquid-cooling loop may be formed by connecting two heat exchangers (heat exchangers 1 and 2), the liquid-cooling condenser, the water pump 2, the power electronic device, pipelines, and the fluid diverter. The low-temperature coolant first flows through the liquid-cooling condenser to absorb heat from the liquid-cooling condenser, and the temperature of the coolant rises. Then, the coolant flows through the power electronic device cold plate to cool the power electronic device. Finally, the coolant sequentially flows through the two heat exchangers to dissipate heat to the air, and the temperature of the coolant decreases.

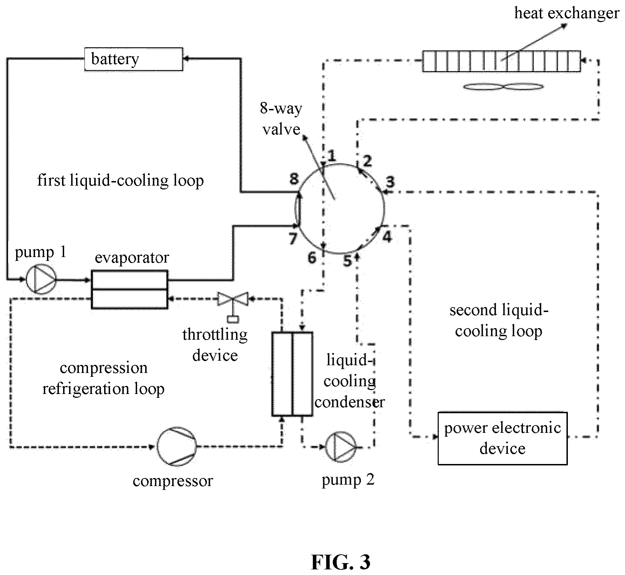

Referring to FIG. 3, one heat exchanger is provided. The energy storage thermal management system includes: one heat exchanger, two water pumps, one 8-way valve as the fluid diverter (the fluid diverter may also be a valve group composed of multiple valves), a battery, a power electronic device, and one compression refrigeration loop.

The energy storage thermal management system has three loops, namely a first liquid-cooling loop, the compression refrigeration loop, and a second liquid-cooling loop. FIG. 3 shows a schematic view of the system in the first mode. The fluid diverter includes an 8-way valve. The controller is configured to control a passageway node 1 to connect a passageway node 6, a passageway node 2 to connect a passageway node 3, a passageway node 4 to connect a passageway node 5, and a passageway node 7 to connect a passageway node 8, in the 8-way valve. The first liquid-cooling loop is formed by connecting the water pump 1, the evaporator, the battery, pipelines, and the fluid diverter. The low-temperature coolant passes through the battery cold plate to cool the battery, and the temperature of the coolant rises. Then, the coolant flows through the evaporator to transfer heat to the refrigerant, and the temperature of the coolant decreases. The compression refrigeration loop consists of a compressor, the evaporator, a liquid-cooling condenser, a throttle device and so on. The low-temperature liquid refrigerant absorbs heat from the first liquid-cooling loop in the evaporator and vaporizes into gaseous refrigerant, and then it is compressed by the compressor into high-temperature and high-pressure gaseous refrigerant. Then, the refrigerant flows through the liquid-cooling condenser to transfer heat to the second liquid-cooling loop and liquefies into high-temperature and high-pressure liquid refrigerant, and passes through the throttle device to become low-temperature and low-pressure liquid refrigerant. The second liquid-cooling loop is formed by connecting the heat exchanger, the liquid-cooling condenser, the water pump 2, the power electronic device, the pipelines, and the fluid diverter. The low-temperature coolant first flows through the liquid-cooling condenser to absorb heat from the liquid-cooling condenser, and the temperature of the coolant rises. Then, the coolant flows through the power electronic device cold plate to cool the power electronic device. Finally, the coolant flows through the heat exchanger to dissipate heat to the air, and the temperature of the coolant decreases.

In another embodiment of the present application, the energy storage thermal management system may be implemented in other ways. Specifically, in a case that the fluid diverter in the energy storage thermal management system includes a solenoid valve with multiple preset passageways, the controller controls a corresponding passageway in the valve assembly with multiple preset passageways to be opened, so that the power electronic device, the fluid diverter, the liquid-cooling condenser, and the at least one heat exchanger are connected to form the first liquid-cooling loop, and the battery, the fluid diverter, and the evaporator in the compression refrigeration loop are connected to form the second liquid-cooling loop. In the embodiment, the first liquid-cooling loop and the compression refrigeration loop share the same evaporator. The power electronic device is located in the second liquid-cooling loop and can dissipate heat through the heat exchanger.

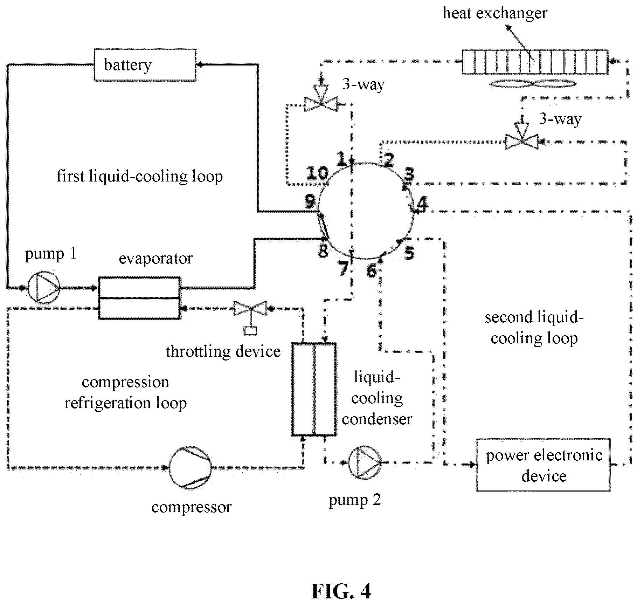

Referring to FIG. 4, the entire energy storage thermal management system includes: a heat exchanger, two water pumps, a 10-way valve (or a valve group composed of multiple valves), two 3-way pipes or 3-way valves, a battery, a power electronic device, and a compression refrigeration loop. The entire energy storage thermal management system has three loops, including the compression refrigeration loop, a first liquid-cooling loop, and a second liquid-cooling loop. FIG. 4 shows a schematic view of the system in the first mode. The fluid diverter includes a 10-way valve. The controller is configured to control a passageway node 1 to connect a passageway node 7, a passageway node 3 to connect a passageway node 4, a passageway node 5 to connect a passageway node 6, and a passageway node 8 to connect a passageway node 9, in the 10-way valve. The first liquid-cooling loop is formed by connecting the water pump 1, an evaporator, the battery, the pipelines, and the fluid diverter. The low-temperature coolant passes through the battery cold plate to cool the battery, and the temperature of the coolant rises. Then, the coolant flows through the evaporator to transfer heat to the refrigerant, and the temperature of the coolant decreases. The compression refrigeration loop is composed of a compressor, the evaporator, a liquid-cooling condenser, a throttle device and so on. The low-temperature liquid refrigerant absorbs heat from the first liquid-cooling loop in the evaporator and vaporizes into gaseous refrigerant, and is compressed by the compressor into high-temperature and high-pressure gaseous refrigerant. Then, the refrigerant flows through the liquid-cooling condenser to transfer heat to the power electronic device and liquefies into high-temperature and high-pressure liquid refrigerant, and passes through the throttle device to become low-temperature and low-pressure liquid refrigerant. The second liquid-cooling loop is formed by connecting the heat exchanger, the liquid-cooling condenser, the water pump 2, the power electronic device, the pipelines, and the fluid diverter. The low-temperature coolant first flows through the liquid-cooling condenser to absorb heat from the condenser, and the temperature of the coolant rises. Then, the coolant flows through the power electronic device cold plate to cool the power electronic device, and finally flows through the heat exchanger to discharge heat to the air, and the temperature of the coolant decreases.

In another embodiment of the present application, in the case where the liquid-cooling condenser and the power electronic device are connected in parallel, the energy storage thermal management system includes at least one heat exchanger and the valve group includes multiple valve assemblies with a preset passageway, the low-temperature coolant output from the at least one heat exchanger is distributed through a specified valve assembly in the fluid diverter and flows through the fluid channels of the liquid-cooling condenser and the power electronic device. The fluid channel of the power electronic device may be the power electronic device cold plate.

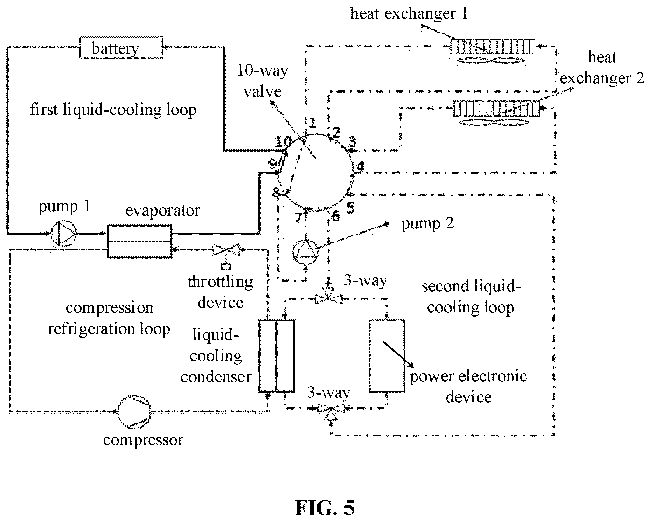

Specifically, with reference to FIG. 5, the entire energy storage thermal management system includes two heat exchangers, two water pumps, a 10-way valve (or a valve group composed of multiple valves), two 3-way pipes or 3-way valves, a battery, a power electronic device, and a compression refrigeration loop. The entire energy storage thermal management system has three loops, including a first liquid-cooling loop, the compression refrigeration loop, and a second liquid-cooling loop. FIG. 5 illustrates a schematic view of the system in the first mode. The fluid diverter includes a 10-way valve. The controller controls a passageway node 9 to connect a passageway node 10, a passageway node 1 to connect a passageway node 8, a passageway node 2 to connect a passageway node 3, a passageway node 4 to connect a passageway node 5, and a passageway node 6 to connect a passageway node 7, in the 10-way valve. The first liquid-cooling loop is formed by connecting the water pump 1, an evaporator, the battery, the pipelines, and the fluid diverter. The low-temperature coolant passes through the battery cold plate to absorb heat from the battery, and the temperature of the coolant rises. Subsequently, the coolant flows through the evaporator to transfer heat to the refrigerant, and the temperature of the coolant decreases. The compression refrigeration loop consists of a compressor, the evaporator, a liquid-cooling condenser, a throttling device, and so on. The low-temperature liquid refrigerant absorbs heat of the battery in the evaporator and vaporizes into gaseous refrigerant. The refrigerant is then compressed into high-temperature and high-pressure gaseous refrigerant by the compressor, and flows through the liquid-cooling condenser to transfer heat to the second liquid-cooling loop and liquefies into high-temperature and high-pressure liquid refrigerant. Then, the refrigerant passes through the throttling device to become low-temperature and low-pressure liquid refrigerant. The second liquid-cooling loop is formed by connecting the two heat exchangers, the liquid-cooling condenser, the two 3-way pipes or 3-way valves, the water pump 2, the power electronic device cold plate, the pipelines, and the fluid diverter. The low-temperature coolant flowing out of the heat exchanger is divided into two paths through one of the two 3-way pipes or 3-way valves: one of the paths is for the heat dissipation of the liquid-cooling condenser, and the other of the paths is for the heat dissipation of the power electronic device. The two paths of the coolant are then merged into one path through the other of the two 3-way pipes or 3-way valves, and sequentially flow through the heat exchanger 2 and the heat exchanger 1 to dissipate heat to the ambient air, and the temperature of the coolant decreases.

From the above, it can be seen that in the first mode, the battery is cooled in the compression refrigeration mode, and the power electronic device is cooled in the liquid-cooling heat exchange mode. The condenser in the compression refrigeration loop is a liquid-cooling condenser, the liquid-cooling condenser and the power electronic device are in the same liquid-cooling loop, and the coolant in the second liquid-cooling loop is used to absorb heat from the condenser in the compression refrigeration loop. In the first mode, there are two optional connection manners between the liquid-cooling condenser and the power electronic device as follows.
1) The liquid-cooling condenser and the power electronic device may be connected in series. The coolant first flows through the liquid-cooling condenser and then flows through the power electronic device cold plate to cool the power electronic device.
2) The liquid-cooling condenser and the power electronic device may be connected in parallel. The coolant is divided into two paths through a 3-way pipe, one of the two paths of the coolant enters the liquid-cooling condenser, and the other of the two paths of the coolant enters the power electronic device cold plate.

2. The second mode is described as follows.

In the second mode, the architecture of the entire energy storage thermal management system may be the same as the architecture of the entire energy storage thermal management system in the first mode. However, the connection manners of the fluid diverter and the operating modes of the loops are different, which are described separately below.

2.1) In a case where the operating mode is the second mode, the controller controls the corresponding passageways of the fluid diverter to be opened, respectively forming a third liquid-cooling loop that includes the battery and a fourth liquid-cooling loop that includes the power electronic device. The third liquid-cooling loop and the fourth liquid-cooling loop are independent from each other. In some embodiments, the energy storage thermal management system includes two heat exchangers, one of the heat exchangers is located in the third liquid-cooling loop, and the other of the heat exchangers is located in the fourth liquid-cooling loop.

In the embodiment, the battery can be cooled in a liquid-cooling heat exchange mode through the third liquid-cooling loop, and the power electronic device can be cooled in a liquid-cooling heat exchange mode through the fourth liquid-cooling loop.

In an embodiment, the energy storage thermal management system may include at least two heat exchangers. In this case, a first heat exchanger of the at least two heat exchangers is located in the third liquid-cooling loop, and a second heat exchanger of the at least two heat exchangers is located in the fourth liquid-cooling loop. The first heat exchanger may be any heat exchanger of the at least two heat exchangers, and the second heat exchanger is a heat exchanger other than the first heat exchanger.

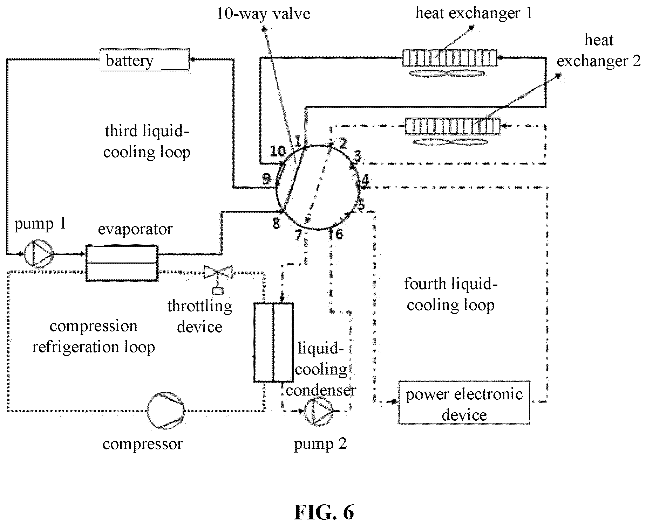

If the architecture of the energy storage thermal management system adopts the architecture shown in FIG. 2, the heat dissipation mode in the second mode specifically refers to FIG. 6. FIG. 6 shows a schematic view of the system in the second mode. In this mode, the fluid diverter includes a 10-way valve. The controller controls the passageway node 9 to connect the passageway node 10, the passageway node 1 to connect the passageway node 8, the passageway node 2 to connect the passageway node 7, the passageway node 3 to connect the passageway node 4, and the passageway node 5 to connect the passageway node 6, in the 10-way valve. The compression refrigeration loop does not work, and both the battery and the power electronic device are cooled in a liquid-cooling heat exchange mode. The water pump 1, the heat exchanger 1, the battery, the pipelines, and the fluid diverter form the third liquid-cooling loop. The low-temperature coolant enters the battery cold plate to cool the battery, and the temperature of the coolant rises. Then, the coolant enters the heat exchanger 1 to dissipate heat to the ambient air, and the temperature of the coolant decreases. The water pump 2, the heat exchanger 2, the power electronic device, and the pipelines constitute the fourth liquid-cooling loop. The low-temperature coolant enters the power electronic device cold plate to cool the power electronic device, and the temperature of the coolant rises. Then, the coolant enters the heat exchanger 2 to dissipate the heat to the ambient air, and the temperature of the coolant decreases.

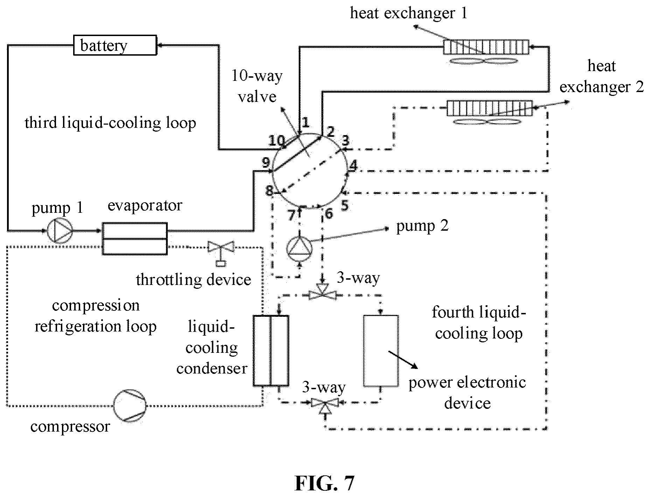

In addition, if the architecture of the entire energy storage thermal management system adopts the architecture shown in FIG. 5, the heat dissipation mode in the second mode specifically refers to FIG. 7. FIG. 7 shows a schematic view of the system in the second mode. In this mode, the fluid diverter includes a 10-way valve. The controller controls the passageway node 1 to connect the passageway node 10, the passageway node 2 to connect the passageway node 9, the passageway node 3 to connect the passageway node 8, the passageway node 4 to connect the passageway node 5, and the passageway node 6 to connect the passageway node 7, in the 10-way valve. The compression refrigeration loop does not work, and both the battery and the power electronic device are cooled in a liquid-cooling heat exchange mode. The water pump 1, the battery, the heat exchanger 1, and the pipelines constitute the third liquid-cooling loop. The low-temperature coolant enters the battery cold plate to cool the battery, and the temperature of the coolant rises. Then, the coolant enters the heat exchanger 1 to dissipate the heat to the ambient air, and the temperature of the coolant decreases. The water pump 2, the heat exchanger 1, the power electronic device, the pipelines, and the fluid diverter are connected to form the fourth liquid-cooling loop. The low-temperature coolant enters the power electronic device cold plate to cool the power electronic device, and the temperature of the coolant rises. Then, the coolant enters the heat exchanger 2 to dissipate the heat to the ambient air, and the temperature of the coolant decreases.

2.2) In the second mode, the controller controls the corresponding passageways of the fluid diverter to be opened, forming a fifth liquid-cooling loop. The battery and the power electronic device are connected in series within the fifth liquid-cooling loop and share the same heat exchanger for heat dissipation. In the embodiment, through the fifth liquid-cooling loop, the battery and the power electronic device can be cooled in a liquid-cooling heat exchange mode.

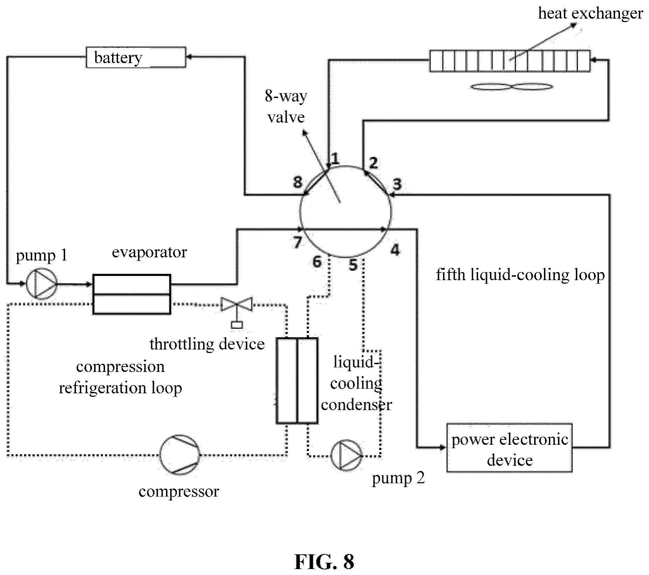

If the architecture of the entire energy storage thermal management system adopts the architecture shown in FIG. 3, the heat dissipation mode in the second mode specifically refers to FIG. 8. FIG. 8 shows a schematic view of the system in the second mode. In this mode, the fluid diverter includes an 8-way valve. The controller controls the passageway node 1 to connect the passageway node 8, the passageway node 2 to connect the passageway node 3, and the passageway node 4 to connect the passageway node 7, in the 8-way valve. The compression refrigeration loop does not work, and both the battery and the power electronic device are cooled in the liquid-cooling heat exchange mode. The water pump 2 is shielded by the 8-way valve. The battery, the power electronic device, the water pump 1, the heat exchanger, and the fluid diverter are connected to form the fifth liquid-cooling loop, and the water pump 1 provides driving force for the loop. The low-temperature coolant enters the battery cold plate to cool the battery, and the temperature of the coolant rises. Then the coolant enters the power electronic device cold plate to cool the power electronic device, and the temperature of the coolant further rises. Finally, the high-temperature coolant flows through the heat exchanger to dissipate heat to the ambient air, and the temperature of the coolant decreases.

2.3) The energy storage thermal management system includes at least one heat exchanger. In the case where the operating mode is the second mode, the controller controls the corresponding passageways of the fluid diverter to be opened to form a sixth liquid-cooling loop. The battery and the power electronic device are connected in parallel in the sixth liquid-cooling loop and share the heat exchanger for heat dissipation. In the embodiment, through the sixth liquid-cooling loop, the battery and the power electronic device can be cooled in a liquid-cooling heat exchange mode.

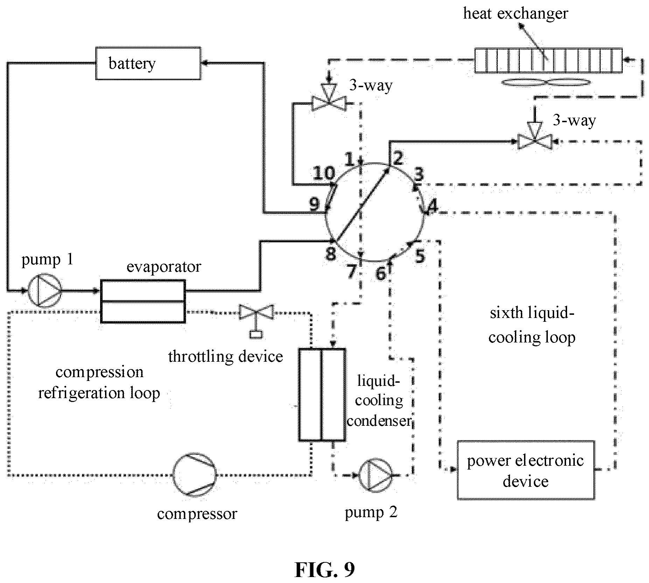

If the architecture of the entire energy storage thermal management system adopts the architecture shown in FIG. 4, the heat dissipation mode in the second mode specifically refers to FIG. 9. FIG. 9 shows a schematic view of the system in the second mode. In this mode, the fluid diverter includes a 10-way valve. The controller controls the passageway node 1 to connect the passageway node 7, the passageway nod 2 to connect the passageway node 8, the passageway node 3 to connect the passageway node 4, the passageway node 5 to connect the passageway node 6, and the passageway node 9 to connect the passageway node 10, in the 10-way valve. The compression refrigeration loop does not work, and both the battery and the power electronic device are cooled in the liquid-cooling heat exchange mode. The sixth liquid-cooling loop is formed by connecting the water pump 1, the battery, the water pump 2, the power electronic device, multiple 3-way pipes or 3-way valves, and the fluid diverter. The low-temperature coolant flows out of the heat exchanger, and is divided into two paths through one of the 3-way pipes or 3-way valves. One of the two paths of the coolant flows through the battery cold plate to cool the battery, and the other of the two paths of the coolant flows through the power electronic device cold plate to cool the power electronic device. Then, the two paths of the coolant are merged into one path through another of the 3-way pipes or 3-way valves, and enter the heat exchanger to dissipate heat to the environment, and the temperature of the coolant decreases.

In summary, in the second mode, the compression refrigeration system is not in operation, and both the battery and the power electronic device are cooled in the liquid-cooling heat exchange mode, which is implemented in the following manners.
1) The liquid-cooling loop where the battery is located and the liquid-cooling loop where the power electronic device is located are independent of each other, and each liquid-cooling loop includes at least one heat exchanger.
2) The battery and the power electronic device share a liquid-cooling loop (the fifth liquid-cooling loop), and the battery and the power electronic device are connected in series in the liquid-cooling loop and share at least one heat exchanger for heat dissipation.
3) The battery and the power electronic device share a liquid-cooling loop (the sixth liquid-cooling loop), and the battery and the power electronic device are connected in parallel in the liquid-cooling loop and share at least one heat exchanger for heat dissipation.

The third mode is described as follows.

In the third mode, the controller controls the corresponding passageways of the fluid diverter to be opened, so that the battery, the power electronic device, and the fluid diverter are connected to form a seventh liquid-cooling loop, so as to utilize the heat of the power electronic device to heat the battery.

In the embodiment, the seventh liquid-cooling loop includes at least one water pump. The battery may be arranged on a battery cold plate, allowing the battery cold plate to serve as a coolant channel of the battery. The power electronic device may be arranged on a power electronic device cold plate, allowing the power electronic device cold plate to serve as a coolant channel of the power electronic device.

Specifically, in the third mode, the architecture of the energy storage thermal management system may be the same as the architecture in the first mode. The connection manners of the valve group and the operating modes of the loops are different, which are introduced respectively below.

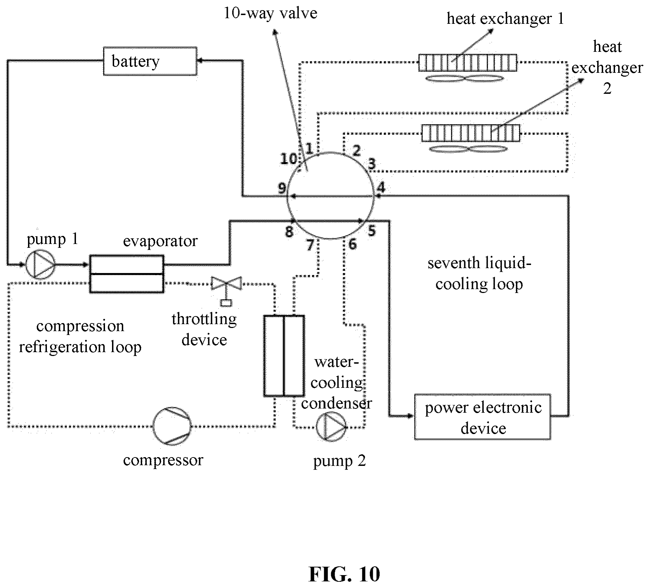

FIG. 10 shows a schematic view of the system in the third mode. In this mode, the compression refrigeration loop does not operate. The controller controls the passageway node 9 to connect the passageway node 4, and the passageway node 8 to connect the passageway node 5, in the 10-way valve. The water pump 2, the heat exchanger 1, and the heat exchanger 2 are shielded from the system. The battery is communicated with the power electronic device through the fluid diverter to form the seventh liquid-cooling loop. The water pump 1 provides a driving force for the loop. The heat of the power electronic device is transferred to the coolant through the power electronic device cold plate, and the temperature of the coolant rises. The high-temperature coolant then enters the battery cold plate to heat the battery.

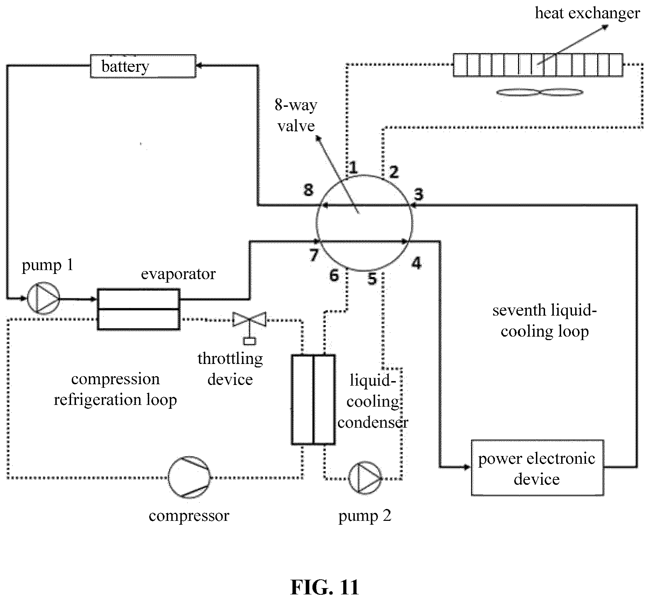

FIG. 11 shows another schematic view of the system in the third mode. In this mode, the compression refrigeration loop does not operate. The controller controls the passageway node 3 to connect the passageway node 8, and the passageway node 4 to connect the passageway node 7, in the 8-way valve. The water pump 2 and the heat exchanger are shielded from the system. The battery is communicated with the power electronic device through the fluid diverter to form the seventh liquid-cooling loop. The water pump 1 provides a driving force for the loop. The heat of the power electronic device is transferred to the coolant through the power electronic device cold plate, and the temperature of the coolant rises. The high-temperature coolant then enters the battery cold plate to heat the battery.

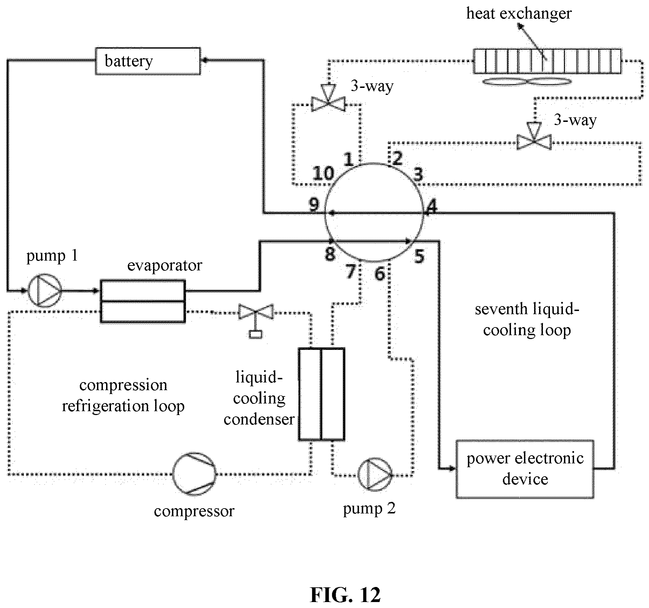

FIG. 12 shows another schematic view of the system in the third mode. In this mode, the compression refrigeration loop does not operate. The controller controls the passageway node 4 to connect the passageway node 9, and the passageway node 5 to connect the passageway node 8, in the 10-way valve. The water pump 2 and the heat exchanger are shielded from the system. The battery is communicated with the power electronic device through the fluid diverter to form the seventh liquid-cooling loop. The water pump 1 provides a driving force for the loop. The heat of the power electronic device is transferred to the coolant through the power electronic device cold plate, and the temperature of the coolant rises. The high-temperature coolant then enters the battery cold plate to heat the battery.

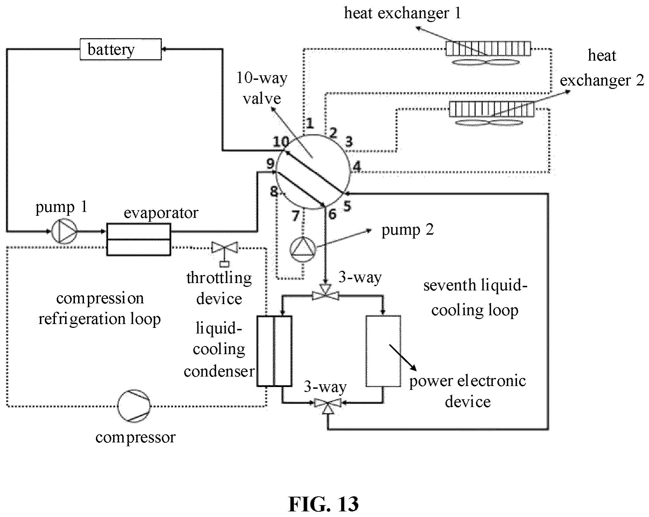

FIG. 13 shows another schematic view of the system in the third mode. In this mode, the compression refrigeration loop does not operate. The controller controls the passageway node 5 to connect the passageway node 10, and the passageway node 6 to connect the passageway node 9, in the 10-way valve. The water pump 2, the heat exchanger 1, and the heat exchanger 2 are shielded from the system. The battery is communicated with the power electronic device through the fluid diverter to form the seventh liquid-cooling loop. The water pump 1 provides a driving force for the loop. The heat of the power electronic device is transferred to the coolant through the power electronic device cold plate, and the temperature of the coolant rises. The high-temperature coolant then enters the battery cold plate to heat the battery.

In some embodiments, the seventh liquid-cooling loop is provided with an electric heater, and the controller is further configured to heat the battery and the power electronic device by using the electric heater.

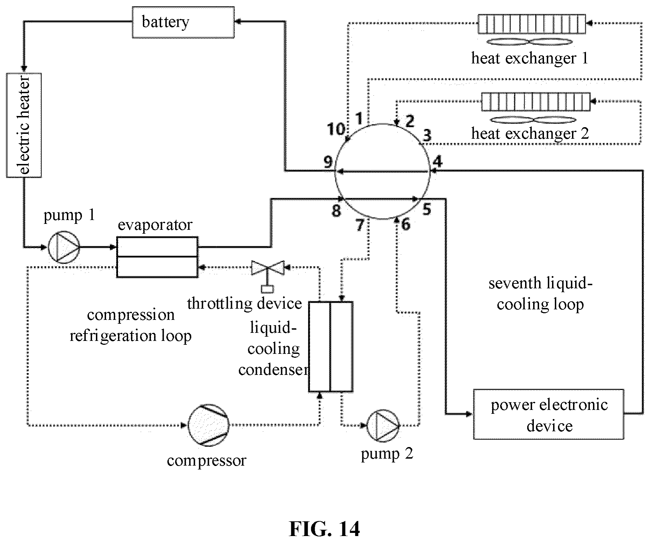

FIG. 14 shows another schematic view of the system in the third mode. In this mode, the compression refrigeration loop does not operate. The controller controls the passageway node 3 to connect the passageway node 8, and the passageway node 4 to connect the passageway node 7, in the 8-way valve. The water pump 2 and the heat exchangers are shielded from the system. The battery, the electric heater, the fluid diverter, and the power electronic device are connected to form the seventh liquid-cooling loop. In the embodiment, the electric heater can provide heat for the battery and the power electronic device, enabling the battery and the power electronic device to reach a startup temperature.

In some embodiments, when the operating mode is the third mode, the controller controls the corresponding passageway of the fluid diverter to be opened, allowing the electric heater, the battery, and the fluid diverter to be connected to form an eighth liquid-cooling loop, thereby utilizing the electric heater to heat the battery.

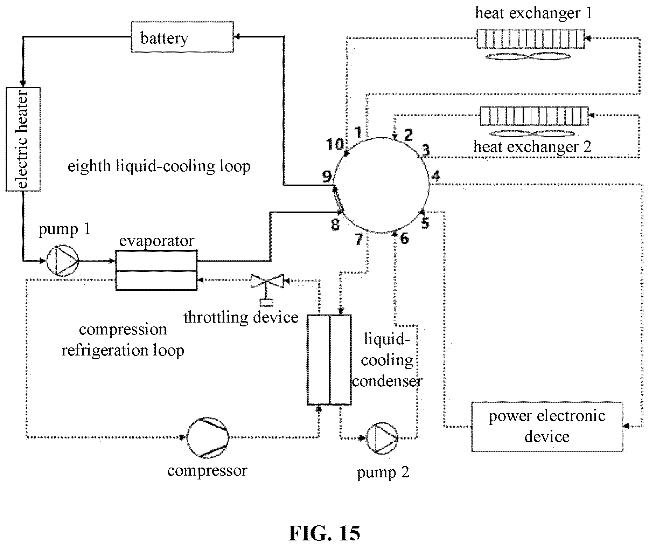

FIG. 15 shows another schematic view of the system in the third mode. In the third mode, the compression refrigeration loop does not operate. The controller controls the passageway node 8 to connect the passageway node 9 in the 10-way valve. The battery, the electric heater, the water pump, and the fluid diverter are connected to form the eighth liquid-cooling loop, and the electric heater is capable of heating the battery.

In the embodiment, the battery and the power electronic device might be cooled simultaneously, and the power electronic device does not need to dissipate heat in the compression refrigeration mode, which integrates multiple operating modes and optimizes the comprehensive energy efficiency. Additionally, the modular design with decentralized architecture improves the energy density and the spatial utilization efficiency of the energy storage system.

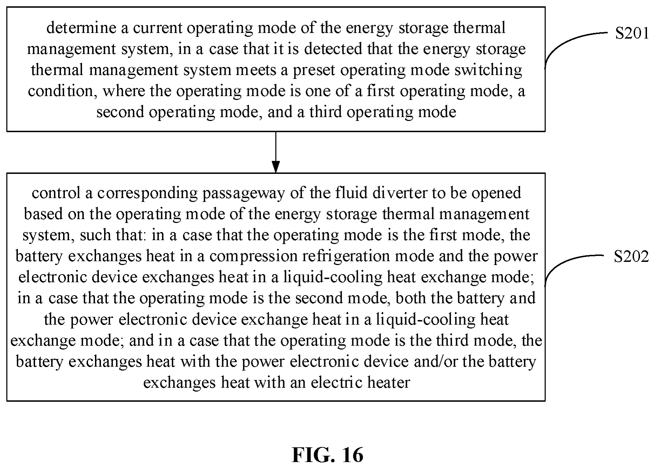

On the basis of the energy storage thermal management system according to the above embodiments, an energy storage thermal management method is provided according to another embodiment of the present application, which is applied to the controller in the energy storage thermal management system described above. The flowchart of the energy storage thermal management method is shown in FIG. 16. The method specifically includes:
S201, determining a current operating mode of the energy storage thermal management system, in a case that the energy storage thermal management system meets a preset operating mode switching condition, where the operating mode is one of a first operating mode, a second operating mode, and a third operating mode;
S202: controlling a corresponding passageway of the fluid diverter to be opened based on the operating mode of the energy storage thermal management system, so that
   in a case that the operating mode is the first mode, the battery exchanges heat in a compression refrigeration mode, and the power electronic device exchanges heat in a liquid-cooling heat exchange mode;
   in a case that the operating mode is the second mode, both the battery and the power electronic device exchange heat in a liquid-cooling heat exchange mode; and
   in a case that the operating mode is the third mode, the battery exchanges heat with the power electronic device, and/or the battery exchanges heat with an electric heater.

In an embodiment of the present application, based on the above implementation process, optionally, the process of detecting that the energy storage thermal management system meets the preset operating mode switching condition includes:
acquiring a current ambient temperature and determining a previous operating mode of the energy storage thermal management system; and
determining that the energy storage thermal management system meets the preset operating mode switching condition, if the current ambient temperature is not within a temperature range corresponding to the previous operating mode, and a minimum temperature difference between the current ambient temperature and the temperature range is greater than a preset hysteresis threshold.

In the embodiment, it may be first determined whether the current operating time of the energy storage thermal management system is the initial time. If the current operating time is the initial time, it may be determined that the energy storage thermal management system meets the operating mode switching condition. If the current operating time is not the initial time, the previous operating mode of the energy storage thermal management system may be determined. Then, if the current ambient temperature is not within the temperature range corresponding to the previous operating mode, and the minimum temperature difference between the current ambient temperature and the temperature range is greater than the preset hysteresis threshold, it is determined that the energy storage thermal management system meets the preset operating mode switching condition. By setting the hysteresis threshold, frequent switching of the operating modes can be avoided.

In an embodiment of the present application, based on the above implementation process, optionally, the determining the current operating mode of the energy storage thermal management system includes:
acquiring the current ambient temperature;
determining a target temperature range within which the current ambient temperature falls; and
determining an operating mode corresponding to the target temperature range as the current operating mode of the energy storage thermal management system.

In the embodiment, different operating modes correspond to different temperature ranges. For example, the first mode corresponds to a first temperature range, the second mode corresponds to a second temperature range, and the third mode corresponds to a third temperature range. Any temperature value in the first temperature range is greater than all temperature values in the second temperature range, and any temperature value in the second temperature range is greater than all temperature values in the third temperature range.

The implementation process of the specific steps in the embodiment refers to the corresponding description in the above embodiments and is not repeated here.

In the embodiment, the energy storage thermal management system includes a controller, a battery, a power electronic device, and a valve group. The valve group includes at least one solenoid valve with a preset passageway. The controller controls a corresponding passageway of a corresponding solenoid valve in the valve group to be opened based on the operating mode of the energy storage thermal management system, such that: in the first mode, the battery dissipates heat in a compression refrigeration mode and the power electronic device dissipates heat in a liquid-cooling heat exchange mode; in the second mode, both the battery and the power electronic device dissipate heat in a liquid-cooling heat exchange mode; and in the third mode, heat of the power electronic device is used to heat the battery. That is, through the present application, heat dissipation of the battery and the power electronic device in different modes is achieved, and different heat dissipation modes are selected based on the different operating modes, meeting the heat dissipation requirements of both the battery and the power electronic device and solving the urgent problem of simultaneously meeting the heat dissipation requirements of the battery and the power electronic device.

The above description of the disclosed embodiments enables those skilled in the art to implement or use the present application. Various modifications to these embodiments are obvious to those skilled in the art. The general principles defined herein may be implemented in other embodiments without departing from the spirit and scope of the present application. Therefore, the present application is not limited to the embodiments described herein, but should be in accordance with the broadest scope consistent with the principles and novel features disclosed herein.

## Claims

1. An energy storage thermal management system, **characterized by** comprising a controller, a battery, a power electronic device, and a fluid diverter; wherein
the controller is configured to:
determine an operating mode of the energy storage thermal management system, wherein the operating mode is any one of a first mode, a second mode, or a third mode that is preset; and
control a corresponding passageway of the fluid diverter to be opened based on the operating mode of the energy storage thermal management system, so that
in a case that the operating mode is the first mode, the battery exchanges heat in a compression refrigeration mode and the power electronic device exchanges heat in a liquid-cooling heat exchange mode;
in a case that the operating mode is the second mode, both the battery and the power electronic device exchange heat in a liquid-cooling heat exchange mode; and
in a case that the operating mode is the third mode, the battery exchanges heat with the power electronic device, and/or the battery exchanges heat with an electric heater.

2. The energy storage thermal management system according to claim 1, comprising a compression refrigeration loop and a liquid-cooling loop, wherein the power electronic device is located in the liquid-cooling loop, the compression refrigeration loop and the liquid-cooling loop share a liquid-cooling condenser, and the energy storage thermal management system exchanges heat through fluid.

3. The energy storage thermal management system according to claim 1, comprising a heat dissipation loop comprising a compression refrigeration loop and a liquid-cooling loop.

4. The energy storage thermal management system according to claim 1, wherein in the case that the operating mode is the first mode, a condenser used in the compression refrigeration mode is a liquid-cooling condenser, and the liquid-cooling condenser and the power electronic device are in a same liquid-cooling loop.

5. The energy storage thermal management system according to claim 4, wherein the liquid-cooling condenser and the power electronic device are connected in series in the liquid-cooling loop.

6. The energy storage thermal management system according to claim 5, wherein
the energy storage thermal management system comprises at least one heat exchanger, and the controller is configured to:
control the corresponding passageway of the fluid diverter to be opened, so that the power electronic device, the at least one heat exchanger, the fluid diverter, and the liquid-cooling condenser are connected to form a first liquid-cooling loop to realize heat dissipation of the power electronic device in the liquid-cooling heat exchange mode, and the battery, the fluid diverter, and an evaporator in the compression refrigeration loop are connected to form a second liquid-cooling loop to realize heat dissipation of the battery in the compression refrigeration mode.

7. The energy storage thermal management system according to claim 6, wherein
the fluid diverter in the energy storage thermal management system comprises a valve assembly with a plurality of preset passageways; and
the controller is configured to control the corresponding passageway of the valve assembly with the plurality of preset passageways to be opened, so that the power electronic device, the fluid diverter, the liquid-cooling condenser, and the at least one heat exchanger are connected to form the first liquid-cooling loop, and the battery, the fluid diverter, and the evaporator in the compression refrigeration loop are connected to form the second liquid-cooling loop.

8. The energy storage thermal management system according to claim 4, wherein
the liquid-cooling condenser and the power electronic device are connected in parallel in the liquid-cooling loop; and
the energy storage thermal management system comprises at least one heat exchanger and the fluid diverter comprises a valve assembly with a plurality of preset passageways, a low-temperature coolant output from the at least one heat exchanger is distributed through a specified valve assembly in the fluid diverter and flows through fluid channels of the liquid-cooling condenser and the power electronic device, respectively.

9. The energy storage thermal management system according to claim 1, wherein
in the case that the operating mode is the second mode, the controller controls the corresponding passageway of the fluid diverter to be opened to form a third liquid-cooling loop comprising the battery and a fourth liquid-cooling loop comprising the power electronic device; and
the third liquid-cooling loop and the fourth liquid-cooling loop are independent of each other.

10. The energy storage thermal management system according to claim 9, comprising two heat exchangers, wherein one of the two heat exchangers is located in the third liquid-cooling loop, and the other of the two heat exchangers is located in the fourth liquid-cooling loop.

11. The energy storage thermal management system according to claim 1, comprising at least one heat exchanger; wherein
in the case that the operating mode is the second mode, the controller controls the corresponding passageway of the fluid diverter to be opened to form a fifth liquid-cooling loop; and the battery and the power electronic device are connected in series in the fifth liquid-cooling loop and share the heat exchanger for heat dissipation.

12. The energy storage thermal management system according to claim 1, comprising at least one heat exchanger; wherein
in the case that the operating mode is the second mode, the controller controls the corresponding passageway of the fluid diverter to be opened to form a sixth liquid-cooling loop; and the battery and the power electronic device are connected in parallel in the sixth liquid-cooling loop and share the heat exchanger for heat dissipation.

13. The energy storage thermal management system according to claim 1, wherein in the case that the operating mode is the third mode, the battery is arranged on a battery cold plate, the power electronic device is arranged on a power electronic device cold plate, and the controller controls the corresponding passageway of the fluid diverter to be opened, so that the battery cold plate, the power electronic device cold plate, and the fluid diverter are connected to form a seventh liquid-cooling loop, so as to use heat of the power electronic device to heat the battery.

14. The energy storage thermal management system according to claim 13, wherein the electric heater is arranged in the seventh liquid-cooling loop, and the controller is further configured to heat the battery and the power electronic device by using the electric heater.

15. The energy storage thermal management system according to claim 1, wherein in the case that the operating mode is the third mode, the corresponding passageway of the fluid diverter is controlled to be opened, so that the electric heater, the battery, and the fluid diverter are connected to form an eighth liquid-cooling loop, so as to use the electric heater to heat the battery.

16. An energy storage thermal management method, **characterized by** being applied to a controller in the energy storage thermal management system according to any one of claims 1 to 15, comprising:
determining a current operating mode of the energy storage thermal management system, in a case that the energy storage thermal management system meets a preset operating mode switching condition, wherein the operating mode is one of a first mode, a second mode, or a third mode; and
controlling a corresponding passageway of the fluid diverter to be opened based on the operating mode of the energy storage thermal management system, so that
in a case that the operating mode is the first mode, the battery exchanges heat in a compression refrigeration mode and the power electronic device exchanges heat in a liquid-cooling heat exchange mode;
in a case that the operating mode is the second mode, both the battery and the power electronic device exchange heat in a liquid-cooling heat exchange mode; and
in a case that the operating mode is the third mode, the battery exchanges heat with the power electronic device and/or the battery exchanges heat with an electric heater.

17. The energy storage thermal management method according to claim 16, wherein the process of detecting that the energy storage thermal management system meets the preset operating mode switching condition comprises:
acquiring a current ambient temperature and determining a previous operating mode of the energy storage thermal management system; and
determining that the energy storage thermal management system meets the preset operating mode switching condition, if the current ambient temperature is not within a temperature range corresponding to the previous operating mode, and a minimum temperature difference between the current ambient temperature and the temperature range is greater than a preset hysteresis threshold.

18. The energy storage thermal management method according to claim 16, wherein the determining the current operating mode of the energy storage thermal management system comprises:
acquiring a current ambient temperature;
determining a target temperature range within which the current ambient temperature falls; and
determining an operating mode corresponding to the target temperature range as the current operating mode of the energy storage thermal management system.
